# EUROPÄISCHE PATENTSCHRIFT

(11) **EP 1 099 601 B1**
(45) Veröffentlichungstag und Bekanntmachung des Hinweises auf die Patenterteilung: **01.08.2007**
(21) Anmeldenummer: 00123767.6
(22) Anmeldetag: 01.11.2000
(51) Int. Cl.: B60Q 3/02

(54) **Kraftfahrzeugleuchte**
Vehicle light
Feu pour véhicule

(30) Priorität: 11.11.1999 DE 29919817 U
(43) Veröffentlichungstag der Anmeldung: 16.05.2001
(73) Patentinhaber: Hella KGaA Hueck & Co., 59552 Lippstadt (DE)
(72) Erfinder: Nachtigall, Klaus, Dipl.-Ing., 79199 Kirchzarten (DE); Zwick, Hubert, Dipl.-Phys., 70173 Stuttgart (DE)
(74) Vertreter: Patent- und Rechtsanwaltssozietät Maucher, Börjes & Kollegen

(56) Entgegenhaltungen:
- EP-A- 0 531 185
- EP-A- 0 677 695
- US-A- 5 038 255
- US-A- 5 325 271
- US-A- 5 519 596

## Beschreibung

Die Erfindung betrifft eine Kraftfahrzeugleuchte mit einem Leuchtengehäuse, in dem mehrere Leuchtdioden auf zumindest einem mit Anschlusskontakten der Leuchtdioden verbundene elektrische Leiterbahnen aufweisenden Leiterbahnträger angeordnet sind, wobei wenigstens eine der Leuchtdioden formschlüssig in eine an dem Leuchtengehäuse vorgesehenen Aufnahme eingreift.

Aus EP 0 531 185 B1 ist bereits eine Kraftfahrzeugleuchte der eingangs genannten Art bekannt, die einen als Leiterplatte ausgebildeten Leiterbahnträger aufweist, auf dem mehrere Leuchtdioden angeordnet sind. Der Leiterbahnträger weist mehrere, etwa parallel zueinander angeordnete streifenförmige Bereiche auf, die durch Schlitze voneinander getrennt sind. An einem ihrer beiden schmalseitigen Enden sind die streifenförmigen Bereiche durch einen quer dazu verlaufenden Leiterplattenbereich miteinander verbunden. Auf jedem dieser streifenförmigen Bereiche sind jeweils mehrere Leuchtdioden angeordnet.

Bei der Herstellung des Leiterbahnträgers werden die Leuchtdioden zunächst auf einer ebenen, durchgehenden Leiterplatte montiert und danach werden zum Ausbilden der streifenförmigen Bereiche Schlitze in die Leiterplatte eingebracht. Anschließend werden die streifenförmigen Bereiche bleibend verformt, in dem sie mit ihren freien Enden aus der Ebene der Leiterplatte verschwenkt werden und in ihrer Form an die von der Ebene abweichende Form des Aufnahmebereichs des Leuchtengehäuses angepasst werden, in dem die Leiterplatte eingesetzt werden soll. Das Leuchtengehäuse weist für jede Leuchtdiode jeweils eine Aufnahme auf, in welche die einzelnen Leuchtdioden in Gebrauchsstellung eingesetzt sind. Dabei umschließt die Aufnahme die Leuchtdioden formschlüssig. Die vorbekannte Kraftfahrzeugleuchte ermöglicht zwar eine einfache Bestückung des Leiterbahnträgers in einer Ebene, hat jedoch den Nachteil, dass das Einbringen der streifenförmigen Bereiche in den Leiterbahnträger und das anschließende Verformen dieser Bereiche noch vergleichsweise aufwendig ist. Ungünstig ist außerdem, dass die zwischen den streifenförmigen Bereichen befindlichen Schlitze die Leiterbahnführung der auf dem Leiterbahnträger befindlichen Leiterbahnen behindert. Da die Richtung, in der die einzelnen Leuchtdioden ausgerichtet sind, durch die Krümmung der bleibend verformten streifenförmigen Bereiche des Leiterbahnträgers fest vorgegeben ist, ist bei der Montage der Kraftfahrzeugleuchte das Einsetzen der Leuchtdioden in die diesen jeweils zugeordneten Aufnahmen des Leuchtengehäuses erschwert.

Aus US 5,519,596 A ist auch bereits eine Kraftfahrzeugleuchte bekannt, die ein aus Metall bestehendes plattenförmiges Trägerteil hat, auf dem mehrere Leuchtdioden angeordnet sind. Das Trägerteil weist mehrere elektrisch gegeneinander isolierte Trägerplattenbereiche auf, die durch Schlitze, die von den Leuchtdioden überbrückt werden, miteinander verbunden sind. Dabei bilden diese Plattenbereiche die Stromversorgungsleitungen für die Leuchtdioden. Die einzelnen Trägerplattenbereiche sind bereichsweise als Maschengewebe ausgebildet, das durch Biegeverformung bleibend verformt werden kann, um die Leuchtdiode in ihrer Lage beispielsweise an die Form eines Leuchtengehäuses anzupassen. Ungünstig ist dabei jedoch, dass bei der Biegeverformung der Trägerplattenbereiche Biegekräfte auf die Leuchtdioden übertragen werden können. Ungünstig ist außerdem, dass die als Stromversorgungsleitungen für die Leuchtdioden dienenden Trägerplattenbereiche nur eine gemeinsame Stromversorgung und Ansteuerung der Leuchtdioden ermöglichen.

Aus US-A-5 325 271 ist eine Kraftfahrzeugleuchte bekannt, bei welcher ein prismatischer Körper mit Hilfe eines Flansches befestigt werden kann. An einer Seite hat der prismatische Körper Öffnungen zum Einführen von LEDs, die von einem flexiblen Substrat gehalten werden. Ein Leuchtengehäuse, in welchem mehrere Leuchtdioden angeordnet sind, ist dabei nicht vorgesehen.

Es besteht deshalb die Aufgabe, eine Kraftfahrzeugleuchte der eingangs genannten Art zu schaffen, die eine einfache Montage und eine einfache Leiterbahnführung ermöglicht.

Diese Aufgabe wird dadurch gelöst, dass der Leiterbahnträger zumindest bereichsweise als flexible Trägerfolie ausgebildet ist und dass an beiden der einander abgewandten Flachseiten der Trägerfolie jeweils wenigstens eine Leuchtdiode angeordnet ist.

In vorteilhafter Weise können die Leuchtdioden dadurch bei in Flachlage befindlichem Leiterbahnträger auf diesem montiert werden und danach wird der Leiterbahnträger aus der Flachlage in die für die Gebrauchsstellung erforderliche Lage gebracht. Dabei kann die Trägerfolie gegebenenfalls auch während des Einsetzens der Leuchtdioden in die Aufnahmen des Leuchtengehäuses biegeverformt und in eine für das Einsetzen der Leuchtdioden günstige Lage gebracht werden. Die Leuchtdioden können dadurch auf einfache Weise in die für die gewünschte Lichtverteilung erforderliche Lage gebracht werden, so dass die Lichtverteilung gegebenenfalls auch ohne die Verwendung weiterer optischer Bauteile erreicht werden. Die Trägerfolie kann aus einem elastisch oder plastisch biegeverformbaren und/oder dehnbaren Material bestehen, insbesondere aus Kunststoff. Gegebenenfalls ist es sogar möglich, für Leuchtengehäuse mit unterschiedlich angeordneten und/oder ausgerichteten Leuchtdioden-Aufnahmen den gleichen Leiterbahnträger vorzusehen, und den Leiterbahnträger dann beim Einsetzen in das jeweilige Leuchtengehäuse entsprechend zu verformen. Somit können Entwicklungs-, Herstellungs- und Lagerkosten für die Leiterbahnträger der unterschiedlichen Kraftfahrzeugleuchten eingespart werden.

In vorteilhafter Weise ermöglicht die flexible Trägerfolie aber auch eine einfache Leiterbahnführung der für die Stromversorgung der Leuchtdiode(n) erforderlichen Leiterbahnen. Dabei können die Leiterbahnen quer zueinander verlaufen und/oder in unterschiedlichen Ebenen der Trägerfolie angeordnet sein. Die Leuchtdiode(n) und/oder die Trägerfolie können auch in das die Aufnahme(n) für die Leuchtdiode(n) aufweisende Teil des Leuchtengehäuses eingegossen oder mit diesem umspritzt sein. In diesem Fall werden zunächst die Leuchtdioden auf der Trägerfolie montiert und danach wird die aus Leuchtdiode (n) und Trägerfolie bestehende Anordnung in eine Gieß- oder Spritzgießform eingesetzt und in der gewünschten Lage positioniert. Anschließend werden die in der Form befindlichen Leuchtdioden mit einem fließhähigen, durch Aushärten und/oder Erstarren sich verfestigenden Material ummantelt, vorzugsweise im Hot-molded-Verfahren. Dabei umgrenzt dieses Material die Leuchtdioden vorzugsweise seitlich, während die Lichtaustrittsfläche der Leuchtdioden von dem Material frei bleibt. Die Leuchtdioden können aber auch an ihrer Lichtaustrittsfläche von dem Material der Aufnahme ummantelt sein, wenn diese lichtdurchlässig ist.

Dadurch, dass an beiden der einander abgewandten Flachseiten der Trägerfolie jeweils wenigstens eine Leuchtdiode angeordnet ist, ermöglicht die erfindungsgemäße Kraftfahrzeugleuchte eine gleichmäßige Lichtabgabe in unterschiedliche Richtungen.

Besonders vorteilhaft ist, wenn die Aufnahme als Steckaufnahme ausgebildet ist, in welche die Leuchtdiode aus einer Vormontagestellung in Einsteckrichtung einsteckbar und vorzugsweise gegen einen an dem Leuchtengehäuse vorgesehenen Anschlag in Montagestellung positionierbar ist. Dadurch ist es insbesondere möglich, Leuchtdioden, die in Montagestellung in quer zueinander verlaufenden Ebenen in unterschiedlichen Richtungen geneigt sind, auf einfache Weise in die Aufnahme des Leuchtengehäuses einzusetzen, indem der zu der jeweils einzusetzenden Leuchtdiode benachbarte Trägerfolienbereich während des Einsetzens der Leuchtdiode in die Aufnahme jeweils so ausgerichtet wird, dass die Leuchtdiode mit ihrer Achse in etwa in Einsteckrichtung orientiert ist. Darüber hinaus ermöglichen die Steckaufnahmen aber auch ein einfaches Austauschen des Leiterbahnträgers, falls einmal eine Leuchtdiode defekt sein sollte. Die Leuchtdiode kann in der Aufnahme des Leuchtengehäuses festgeklemmt sein. Die Aufnahme kann dazu eine etwas geringere lichte Weite aufweisen als der Durchmesser oder die Außenabmessung der Leuchtdiode. Dabei besteht die Aufnahme vorzugsweise aus einem gegen die Rückstellkraft ihres Werkstoffs nachgiebigen Material. Auch kann die Aufnahme konisch mit sich in Einsteckrichtung der Leuchtdiode verjüngenden Querschnitt ausgebildet sein. Außerdem kann an der Aufnahme mindestens ein in Gebrauchsstellung der Leuchtdiode zugewandter Vorsprung angeordnet sein, der vorzugsweise wenigstens eine spitze und/oder eine scharfe Kante aufweist, die beim Einsetzen der Leuchtdiode etwas in das Gehäuse der Leuchtdiode eindringt und diese in der Aufnahme fixiert.

Bei einer bevorzugten Ausführungsform der Erfindung ist vorgesehen, dass die Trägerfolie einen zentralen Bereich aufweist, in dem vorzugsweise mehrere Leuchtdioden angeordnet sind, dass beidseits des zentralen Bereichs jeweils wenigstens eine insbesondere laschenförmige Fortsetzung der Trägerfolie vorgesehen ist, dass an dieser Fortsetzung jeweils wenigstens eine Leuchtdiode angeordnet ist, und dass die Fortsetzungen zur Ausleuchtung seitlicher Bereiche in Gebrauchsstellung vorzugsweise aus der Flachlage verschwenkt sind. Dadurch ergibt sich eine einfach montierbare Kraftfahrzeugleuchte, die auch in einer schräg zu dem Abstrahlbereich der Leuchtdiode(n) des Zentralbereichs Licht abstrahlt. Durch die schräge Lichtabstrahlung der seitlichen Leuchtdiode (n) kann beispielsweise bei einer als Innenleuchte zur Beleuchtung eines Fahrzeuginnenraums ausgebildeten Kraftfahrzeugleuchte eine gleichmäßige Beleuchtung des Fahrzeuginnenraums erreicht werden.

Zweckmäßigerweise weist das Leuchtengehäuse einen im Querschnitt etwa U-förmigen Aufnahmebereich auf, indem die Trägerfolie in Montagestellung etwa U-förmig angeordnet ist, wobei an den einander gegenüberliegenden Seitenwandungen dieses Aufnahmebereichs jeweils wenigstens einer als Durchgangslochung ausgebildete Aufnahme vorgesehen ist, in die eine auf der Trägerfolie angeordnete Leuchtdiode formschlüssig eingesetzt ist. Die Trägerfolie ist dann an den beispielsweise als U-Schwenkel ausgebildeten Seitenwandungen des Aufnahmebereichs über die in die dort befindlichen Aufnahmen eingesetzten Leuchtdioden fixiert und kann gegebenenfalls zusätzlich in dem zwischen diesen Leuchtdioden befindlichen zentralen Bereich an dem U-Quersteg der Aufnahme abgestützt sein.

Die Trägerfolie kann wenigstens zwei Teilbereiche aufweisen, in denen jeweils wenigstens eine Leuchtdiode angeordnet ist, wobei diese Teilbereiche durch einen mäanderförmigen, geschlitzten Bereich der Trägerfolie miteinander verbunden sind. Die beiden Teilbereiche der Trägerfolie können dann in der Ebene der Trägerfolie in unterschiedlichen Abständen zueinander angeordnet und insbesondere auseinandergezogen oder aufeinander zubewegt werden. Die Leuchtdioden sind dann bei der Montage der Kraftfahrzeugleuchte noch besser in die Aufnahme des Leuchtengehäuses einsetzbar. Auch kann die Trägerfolie besser an Leuchtengehäuse mit unterschiedlichen Abmessungen und/oder unterschiedlich angeordneten Leuchtdioden-Aufnahmen angepasst werden.

Zweckmäßigerweise ist zusätzlich zu den Leuchtdioden wenigstens ein weiteres elektronisches Bauelement auf der Trägerfolie angeordnet, wobei dieses Bauelement insbesondere Teil einer Steuerelektronik zum Ansteuern der Leuchtdioden ist. Die zusätzlichen Bauelemente können dann zusammen mit den Leuchtdioden auf der Trägerfolie montiert werden. Die Steuerelektronik kann insbesondere eine Einrichtung zur Helligkeitssteuerung wenigstens einer Leuchtdiode und/oder eine Einrichtung zur temperaturabhängigen Einstellung oder Begrenzung des Leuchtdiodenstromes aufweisen.

Nachfolgend sind Ausführungsbeispiele der Erfindung anhand der Zeichnung näher erläutert. Es zeigen zum Teil stärker schematisiert:
- Fig. 1: einen Querschnitt durch eine als Innenleuchte ausgebildete Kraftfahrzeugleuchte,
- Fig. 2: eine Seitenansicht des in Figur 1 gezeigten, als durchgehend flexible Trägerfolie ausgebildeten Leiterbahnträgers mit den darauf befindlichen Leuchtdioden,
- Fig. 3: eine Unteransicht des in Fig. 2 gezeigten Leiterbahnträgers,
- Fig. 4: einen Teilquerschnitt durch die Wandung eines Leuchtengehäuses, die Aufnahmen aufweist, in die Leuchtdioden eingesetzt sind,
- Fig. 5: eine Seitenansicht eines als Starflex-Leiterplatte ausgebildeten Leiterbahnträgers, der mit konventionellen Leuchtdioden und mit SMT-Leuchtdioden bestückt ist und
- Fig. 6: eine Aufsicht auf einen Teilbereich eines flexiblen Leiterbahnträgers, auf dem Leuchtdioden und weitere elektronische Bauelemente angeordnet sind.

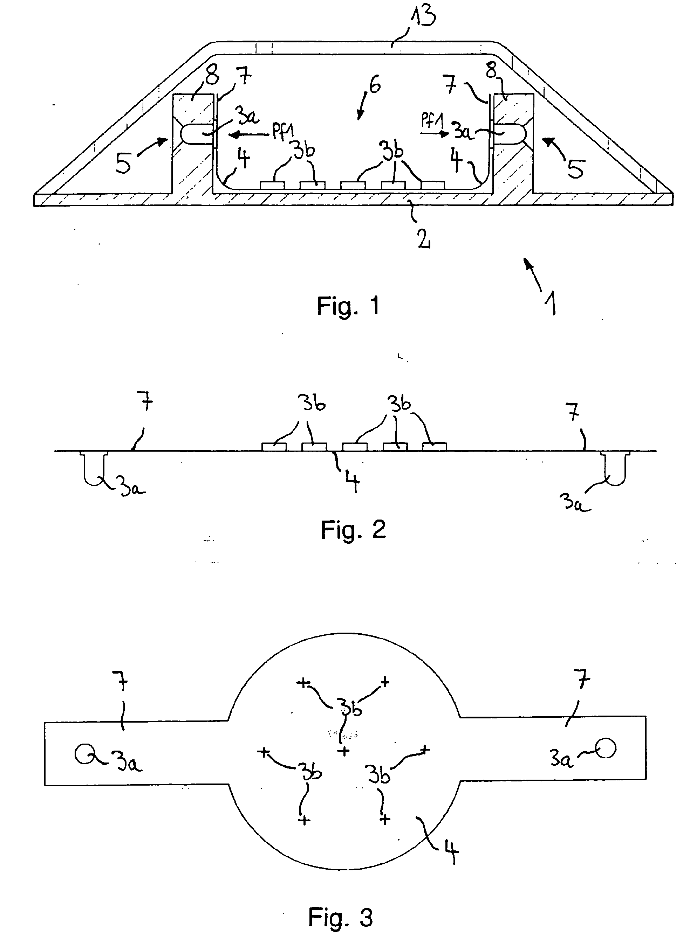

Eine im ganzen mit 1 bezeichnete Kraftfahrzeugleuchte weist ein Leuchtengehäuse 2 auf, in dem mehrere Leuchtdioden 3a, 3b auf einem als flexible Trägerfolie ausgebildeten Leiterbahnträgern 4 angeordnet sind. Die Trägerfolie weist in der Zeichnung nicht dargestellte Leiterbahnen zur Stromversorgung der Leuchtdioden 3a, 3b auf, die mit Anschlusskontakten der Leuchtdioden 3a, 3b verbunden sind. In Fig. 1, 4 und 5 ist erkennbar, dass jeweils mehrere der Leuchtdioden 3a formschlüssig in an dem Leuchtengehäuse 2 vorgesehene Aufnahmen 5 eingreifen. Über diese Leuchtdioden 3a ist der Leiterbahnträger 4 an dem Leuchtengehäuse 2 befestigt.

Die Aufnahmen 5 sind jeweils als Steckaufnahmen ausgebildet, in welche die Leuchtdioden 3a aus einer Vormontagestellung in der jeweils durch den Pfeil Pf1 markierten Einsteckrichtung einsteckbar sind. Die Leuchtdioden 3a weisen an ihrem dem Leiterbahnträger 4 zugewandten Gehäuseende jeweils einen Ringbund auf, der in Montagestellung der Leuchtdioden 3a an einem an der Aufnahme 5 vorgesehenen, dem Ringbund zugewandten Anschlag anliegt.

Bei der Herstellung der Kraftfahrzeugleuchte 1 werden die Leuchtdioden 3a, 3d bei in Flachlage befindlichem Leiterbahnträger 4 (Fig. 2) auf diesen montiert und danach wird der Leiterbahnträger 4 mit den darauf befindlichen Leuchtdioden 3a, 3b in den Aufnahmebereich 6 des Leuchtengehäuses 2 eingesetzt, wobei die Leuchtdioden 3a in die Aufnahmen 5 eingesteckt werden. Die Kraftfahrzeugleuchte 1 ist somit einfach und kostengünstig montierbar.

In Fig. 2 und 3 ist erkennbar, dass die Trägerfolie einen zentralen Bereich aufweist, in dem mehrere in SMT-Technik ausgebildete Leuchtdioden 3b angeordnet sind. In Fig. 3 sind diese Leuchtdioden 3b jeweils durch Kreuze schematisch angedeutet. Beidseits des zentralen Bereichs ist jeweils eine laschenförmige Fortsetzung 7 der Trägerfolie vorgesehen, die benachbart zu ihrem dem zentralen Bereich abgewandten freien Ende jeweils eine konventionelle Leuchtdiode 3a trägt. In Fig. 3 ist erkennbar, dass diese laschenförmigen Fortsetzungen diametral gegenüberliegend mit ihren Erstreckungsrichtungen etwa radial zum Zentrum des zentralen Bereichs der Trägerfolie angeordnet sind. Wie in Fig. 2 besonders gut erkennbar ist, sind die an den laschenförmigen Fortsetzungen 7 befindlichen Leuchtdioden 3a jeweils an der den Leuchtdioden 3b des zentralen Bereichs abgewandten Rückseite der Trägerfolie angeordnet.

Fig. 1 zeigt die Trägerfolie in Montagestellung. Deutlich ist erkennbar, dass die Leuchtdioden 3a der laschenförmigen Fortsetzungen 7 in an den Seitenwandungen 8 des im Querschnitt U-förmigen Aufnahmebereichs 6 des Leuchtengehäuses 2 angeordneten Aufnahmen 5 eingesetzt sind. Diese Aufnahme 5 sind durch Lochungen gebildet, welche die Seitenwand 8 des U-förmigen Aufnahmebereichs 6 durchsetzen. Dabei sind die Leuchtdioden 3a mit ihrer Lichtaustrittsfläche an dem der Trägerfolie abgewandten Ende der Aufnahme 5 angeordnet, so dass sie an der dem Leiterbahnträger 4 abgewandten Rückseite der Seitenwandung Licht in einen seitlichen Bereich abstrahlen können. In Fig. 1 ist weiter erkennbar, dass der zentrale Bereich der Trägerfolie etwa parallel zum Boden des U-förmigen Aufnahmebereichs 6 angeordnet ist und rückseitig gegen diesen abgestützt ist bzw. an diesem anliegt. An der Vorderseite des zentralen Bereichs sind die Leuchtdioden 3b angeordnet, die mit ihrer Abstrahlrichtung etwa rechtwinklig zur Ebene des Bodens des U-förmigen Aufnahmebereichs 6 ausgerichtet sind.

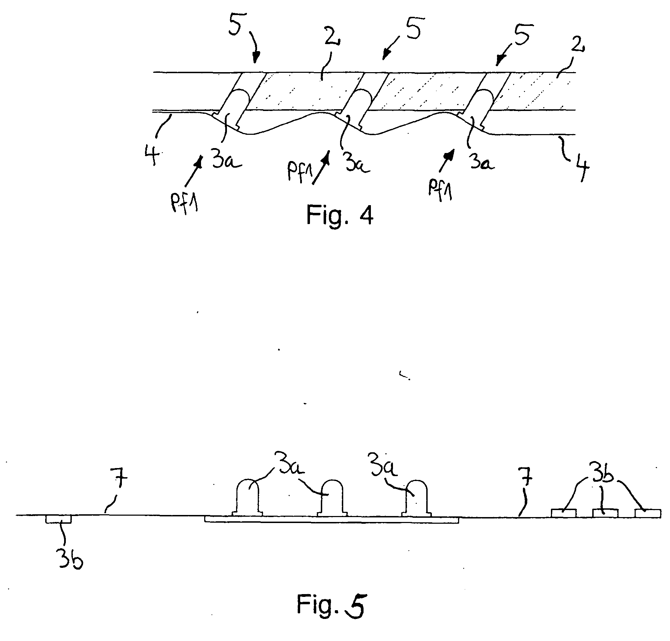

Bei dem Ausführungsbeispiel nach Fig. 4 sind die Aufnahmen 5 jeweils schräg zur Ebene der Wandung des Leuchtengehäuses 2 angeordnet. Deutlich ist erkennbar, dass die Aufnahmen 5 jeweils als Durchgangslochung ausgebildet sind, und dass diese Durchgangslochungen mit ihren Achsen jeweils parallel zueinander angeordnet sind.

Bei dem Ausführungsbeispiel nach Fig. 5 weisen die Leiterbahnträger 4 einerseits flexible und andererseits aber auch weitgehend starre Bereiche auf. Dabei ist der zentrale Leiterplattenbereich jeweils starr ausgebildet, während die seitlich daran angeordneten Fortsetzungen flexibel sind. Deutlich ist erkennbar, dass der zentrale starre Bereich des Leiterbahnträgers 4 eine größere Dicke aufweist als die flexiblen Fortsetzungen. Selbstverständlich sind auch beliebige andere Anordnungen von miteinander verbundenen starren und flexiblen Leiterbahnträgern denkbar, beispielsweise eine Anordnung, bei welcher der flexible Bereich mittig und die starren Bereiche an den Rändern des Leiterbahnträgers 4 vorgesehen sind.

Bei dem Ausführungsbeispiel nach Fig. 5 sind die Leuchtdioden 3b bei einem der beidseits des zentralen Leiterbahnträgerbereichs angeordneten Fortsetzungen 7 an der Vorderseite und bei der anderen Fortsetzung 7 an der Rückseite des Leiterbahnträgers 4 angeordnet sind.

Dabei ist nicht dargestellt, dass an einer Seite des zentralen Leiterplattenbereichs mehrere laschenartige Fortsetzungen vorgesehen sein können, die quer zu ihrer Erstreckungsrichtung nebeneinander angeordnet sind. In Montagestellung können derartige mehrere Fortsetzungen 7 in unterschiedlichen Winkeln gegenüber der Ebene des zentralen Bereichs geneigt sein, wodurch eine gewünschte Lichtverteilung ohne die Verwendung mehrerer optischer Bauteile, wie zum Beispiel Linsen oder Umlenkspiegeln, erreicht werden kann.

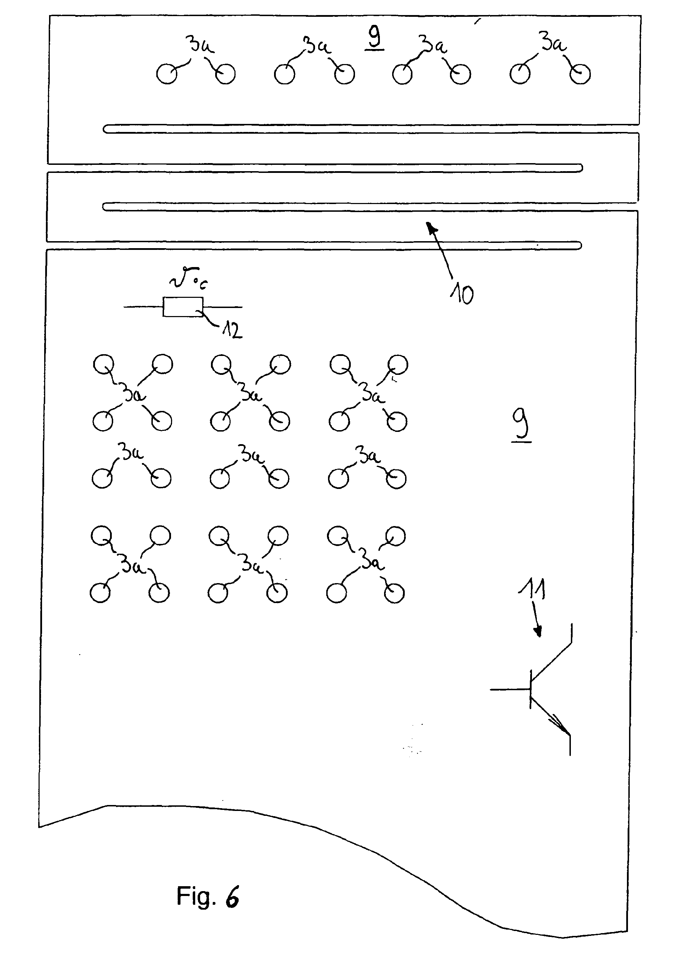

Bei dem in Fig. 6 gezeigten Ausführungsbeispiel weist die Trägerfolie zwei Teilbereiche 9 auf, die durch einen mäanderförmigen, geschlitzten Bereich 10 der Trägerfolie miteinander verbunden sind. In jedem der Teilbereiche 10 ist jeweils eine Gruppe mit mehreren Leuchtdioden 3a angeordnet. Mittels des geschlitzten Bereichs 10 können die beiden Teilbereiche 9 der Trägerfolie in der Ebene der Trägerfolie quer zur Erstreckungsrichtung der Schlitze aus einer Ruhelage aufeinander zu- und voneinander weg bewegt werden. Außerdem können die Teilbereiche 10 in Erstreckungsrichtung der Schlitze gegeneinander verschoben werden. Der mäanderförmige Bereich 10 ermöglicht es aber auch, die Teilbereiche 9 der Trägerfolie mit ihren Ebenen gegeneinander zu verschwenken.

In Fig. 6 ist noch erkennbar, dass zusätzlich zu den Leuchtdioden 3a auf der Trägerfolie eine in der Zeichnung nur schematisch dargestellte Steuerelektronik 11mit einem Temperaturfühler 12 angeordnet ist. Die Steuerelektronik 11 weist eine Stromsteuerschaltung für die Leuchtdioden 3a auf, die über Leiterbahnen einerseits mit dem Temperaturfühler 12 und andererseits mit den elektrischen Anschlüssen der Leuchtdioden 3a verbunden ist. Mittels der Stromsteuerschaltung wird der Betriebsstrom der Leuchtdioden 3a in Abhängigkeit von der Umgebungstemperatur gesteuert. Oberhalb einer vorgegebenen Grenztemperatur wird der Betriebsstrom der Leuchtdiode 3a mit zunehmender Temperatur reduziert. Dabei kann die Reduzierung des Betriebsstroms in Stufen oder kontinuierlich erfolgen. Unterhalb der Grenztemperatur werden die Leuchtdioden mit einem konstanten Betriebsstrom bestromt.

In Fig. 1 ist noch erkennbar, dass das Leuchtengehäuse 2 lichtabstrahlseitig eine optisch transparente Lichtscheibe 13 aufweist. In die Lichtscheibe 13 können gegebenenfalls optische Streuelemente integriert sein.

## Patentansprüche

1. Kraftfahrzeugleuchte (1) mit einem Leuchtengehäuse (2), in dem mehrere Leuchtdioden (3a, 3b) auf zumindest einem mit Anschlusskontakten der Leuchtdioden (3a, 3b) verbundene elektrische Leiterbahnen aufweisenden Leiterbahnträger (4) angeordnet sind, wobei wenigstens eine der Leuchtdioden (3a, 3b) formschlüssig in eine an dem Leuchtengehäuse (2) vorgesehenen Aufnahme (5) eingreift, **dadurch gekennzeichnet, dass** der Leiterbahnträger (4) zumindest bereichsweise als flexible Trägerfolie ausgebildet ist und dass an beiden der einander abgewandten Flachseiten der Trägerfolie jeweils wenigstens eine Leuchtdiode (3a, 3b) angeordnet ist.

2. Kraftfahrzeugleuchte (1) nach Anspruch 1, **dadurch gekennzeichnet, dass** die Aufnahme (5) als Steckaufnahme ausgebildet ist, in welche die Leuchtdiode (3a, 3b) aus einer Vormontagestellung in Einsteckrichtung (Pf1) einsteckbar und vorzugsweise gegen einen an dem Leuchtengehäuse (2) vorgesehenen Anschlag in Montagestellung positionierbar ist.

3. Kraftfahrzeugleuchte (1) nach einem der Ansprüche 1 oder 2, **dadurch gekennzeichnet, dass** die Trägerfolie einen zentralen Bereich aufweist, in dem vorzugsweise mehrere Leuchtdioden (3a, 3b) angeordnet sind, dass beidseits des zentralen Bereichs jeweils wenigstens eine insbesondere laschenförmige Fortsetzung (7) der Trägerfolie vorgesehen ist, dass an dieser Fortsetzung (7) jeweils wenigstens eine Leuchtdiode angeordnet ist, und dass die Fortsetzungen zur Ausleuchtung seitlicher Bereiche in Gebrauchsstellung vorzugsweise aus der Flachlage verschwenkt sind.

4. Kraftfahrzeugleuchte (1) nach einem der Ansprüche 1 bis 3, **dadurch gekennzeichnet, dass** das Leuchtengehäuse einen im Querschnitt etwa U-förmigen Aufnahmebereich (6) aufweist, in dem die Trägerfolie etwa U-förmig angeordnet ist, und dass an den einander gegenüberliegenden Seitenwandungen (8) dieses Aufnahmebereichs jeweils wenigstens eine als Durchgangslochung ausgebildete Aufnahme (5) vorgesehen ist, in die eine auf der Trägerfolie angeordnete Leuchtdiode (3a) formschlüssig eingesetzt ist.

5. Kraftfahrzeugleuchte (1) nach einem der Ansprüche 1 bis 4, **dadurch gekennzeichnet, dass** die Trägerfolie wenigstens zwei Teilbereiche (9) aufweist, in denen jeweils wenigstens eine Leuchtdiode (3a, 3b) angeordnet ist und dass diese Teilbereiche (9) durch einen mäanderförmigen, geschlitzten Bereich (10) der Trägerfolie miteinander verbunden sind.

6. Kraftfahrzeugleuchte (1) nach einem der Ansprüche 1 bis 5, **dadurch gekennzeichnet, dass** zusätzlich zu den Leuchtdioden (3a, 3b) wenigstens ein weiteres elektronisches Bauelement auf der Trägerfolie angeordnet ist und dass dieses Bauelement insbesondere Teil einer Steuerelektronik (11) zum Ansteuern der Leuchtdioden (3a, 3b) ist.

## Claims

1. Vehicle light (1) having a light housing (2) in which a plurality of light-emitting diodes (3a, 3b) are arranged on at least one conductor carrier (4) comprising electrical conductors connected to connecting contacts of the light-emitting diodes (3a, 3b), wherein at least one of the light-emitting diodes (3a, 3b) engages in interlocking manner in a receptacle (5) provided on the light housing (2), **characterised in that** the conductor carrier (4) is formed, at least in parts, as a flexible carrier film and **in that** at least one light-emitting diode (3a, 3b) is arranged on each of the flat sides of the carrier film facing away from each other.

2. Vehicle light (1) according to claim 1, **characterised in that** the receptacle (5) is formed as a plug socket into which the light-emitting diode (3a, 3b) can be plugged in the direction of insertion (Pf1) from a pre-assembly position and can preferably be positioned against a stop provided on the light housing (2) in the assembly position.

3. Vehicle light (1) according to one of claims 1 or 2, **characterised in that** the carrier film has a central region in which preferably a plurality of light-emitting diodes (3a, 3b) are arranged, **in that** on each side of the central region is provided at least one in particular tongue-shaped extension (7) of the carrier film, **in that** at least one light-emitting diode is arranged on each extension (7) and **in that** the extensions are preferably swivelled out of the flat position to illuminate lateral areas in the position of use.

4. Vehicle light (1) according to one of claims 1 to 3, **characterised in that** the light housing has a socket region (6) which is substantially U-shaped in cross-section, in which the carrier film is arranged substantially in a U-shape, and **in that** at least one receptacle (5) in the form of a through-hole is provided on each of the opposing side walls (8) of this socket region, into which the light-emitting diode (3a) arranged on the carrier film is inserted in interlocking engagement.

5. Vehicle light (1) according to one of claims 1 to 4, **characterised in that** the carrier film has at least two partial regions (9) in which at least one light-emitting diode (3a, 3b) is arranged and **in that** these partial regions (9) are joined together by a meandering slotted region (10) of the carrier film.

6. Vehicle light (1) according to one of claims 1 to 5, **characterised in that** in addition to the light-emitting diodes (3a, 3b) at least one other electronic component is arranged on the carrier film and **in that** this component is, in particular, part of an electronic control device (11) for controlling the light-emitting diodes (3a, 3b).

## Revendications

1. Feu (1) pour véhicule, avec un boîtier de feu (2) dans lequel plusieurs diodes électroluminescentes (3a, 3b) sont disposées sur au moins un support (4) de pistes conductrices présentant des pistes électroconductrices reliées à des contacts de connexion des diodes électroluminescentes (3a, 3b), sachant qu'au moins une des diodes électroluminescentes (3a, 3b) s'engage positivement ou par coopération de forme dans un logement (5) prévu sur le boîtier de feu (2), **caractérisé en ce que** le support (4) de pistes conductrices est réalisé au moins partiellement sous forme de film de support flexible, et **en ce qu'**au moins une diode électroluminescente (3a, 3b) est disposée sur chacun des deux côtés plats mutuellement opposés du film de support.

2. Feu (1) pour véhicule selon la revendication 1, **caractérisé en ce que** le logement (5) est réalisé en tant que logement d'emboîtement dans lequel la diode électroluminescente (3a, 3b) peut être emboîtée dans la direction d'emboîtement (Pf1) à partir d'une position de prémontage et peut être positionnée en position de montage de préférence contre une butée prévue sur le boîtier de feu (2).

3. Feu (1) pour véhicule selon la revendication 1 ou 2, **caractérisé en ce que** le film de support présente une région centrale dans laquelle sont de préférence disposées plusieurs diodes électroluminescentes (3a, 3b), **en ce qu'**il est prévu de part et d'autre de la région centrale au moins un prolongement respectif (7), notamment en forme de patte, du film de support, **en ce qu'**au moins une diode électroluminescente est disposée sur chaque prolongement (7), et **en ce que** les prolongements sont de préférence, en position d'utilisation, pivotées hors de leur position plate afin d'éclairer des zones latérales.

4. Feu (1) pour véhicule selon l'une des revendications 1 à 3, **caractérisé en ce que** le boîtier de feu présente une région réceptrice (6) à section approximativement en forme de U, dans laquelle le film de support est disposé approximativement en forme de U, et **en ce qu'**au moins un logement respectif (5) réalisé sous forme de trou débouchant est prévu sur chacune des parois latérales en vis-àvis (8) de cette région réceptrice, logement dans lequel est insérée en engagement positif ou par coopération de forme une diode électroluminescente (3a) disposée sur le film de support.

5. Feu (1) pour véhicule selon l'une des revendications 1 à 4, **caractérisé en ce que** le film de support présente au moins deux régions partielles (9) dans chacune desquelles est disposée au moins une diode électroluminescente (3a, 3b), et **en ce que** ces régions partielles (9) sont mutuellement reliées par une région fendue (10) en forme de méandres du film de support.

6. Feu (1) pour véhicule selon l'une des revendications 1 à 5, **caractérisé en ce qu'**au moins un composant électronique supplémentaire est disposé en plus des diodes électroluminescentes (3a, 3b) sur le film de support, et **en ce que** ce composant fait notamment partie d'un équipement électronique de commande (11) pour l'asservissement des diodes électroluminescentes (3a, 3b).
